# EUROPEAN PATENT APPLICATION

(11) **EP 2 276 077 A2**
(43) Date of publication of application: **19.01.2011**
(21) Application number: 09742822.1
(22) Date of filing: 04.05.2009
(51) Int. Cl.: H01L 33/00

(54) **PRESS FORGED METAL HOUSING FOR LEDS AND AN LED METAL PACKAGE USING THE METAL HOUSING**

(30) Priority: 06.05.2008 KR 20080041641
(71) Applicant: Yoon, Sung No, Seoul 152-051 (KR); Kim, Min Kong, Seoul 137-814 (KR)
(72) Inventor: Yoon, Sung No, Seoul 152-051 (KR); Kim, Min Kong, Seoul 137-814 (KR)
(74) Representative: Catherine, Alain
(86) International application number: PCT/KR2009/002347
(87) International publication number: WO 2009/136716

(57) **Abstract**

A press-forged LED metal housing includes a housing body having a chip mount formed in an upper middle portion of the housing body and mounting one or more LED therein; and a reflecting projection formed around the chip mount on the upper face of the housing body integrally with the housing body, wherein the housing body and the reflecting projection are made of a metal material.

The LED housing can be have a regular volume (size) and thus be standardized by forming the housing body for mounting the LED chip therein and the reflecting projection with metal material and it is possible to automate, with a high working ratio, a series of processes of automatically mounting the LED, connecting the electrode lead, mounting the lead frame and dispensing resin (casting resin or silicon), and thus massively produce the LED metal package and reduce (lower) a production cost by the standardization of the LED housing. Also, illuminance of the reflecting face is raised and thus brightness of the lighting device package can be enhance by forming the housing body and the reflecting projection with metal by press-forging and there is no lowering in the brightness and thus light emitted from the LED can be utilized efficiently since the reflecting face is made of metal.

## Description

### [Technical Field]

The present invention relates to a metal housing which is made of a metal material by press-forging and is for mounting a light emitting diode (LED) therein to fabricate a LED package, and a LED metal package using the same.

More particularly, the present invention relates to a LED metal housing which includes a housing body having a chip mount formed in an upper middle portion of the housing body and mounting one or more LED therein; and a reflecting projection formed around the chip mount on the upper face of the housing body integrally with the housing body, wherein the housing body and the reflecting projection are made of a metal material, and a press-forged LED metal package formed using the same.

### [Background Art]

As is well known, LED is a device using a phenomenon that light is emitted when current flows in a forward direction through a pn junction of a compound semiconductor (e.g. GaP, GaAs, GaN), is used variously in lighting equipments, backlights for billboard and liquid crystal display (LCD) since it has many advantages that it has better good light conversion efficiency and longer life time than a nichrome bulb due to a small heat radiating amount.

Conventional LED housings for manufacturing a LED package with LED chips are disclosed in Korean patent application publication No. 10-2001-89757, and Korean patent Nos. 10-505508, 10-631903, 10-665117 and 10-795178.

In the conventional LED housings disclosed in the above Korean patent application publication and Korean patents, a chip mount and a housing body are formed integrally with each other or the chip mount is formed separately and coupled to the housing body.

The conventional LED housing as described above is formed by mixing resin and metal formed with circuits or manufactured using mixture of resin and metal (powder) by metal injection molding.

The conventional LED housing formed of resin has a low thermal resistance since only the portion for mounting LED chips and connecting to electrodes is made of metal and the rest portion including a reflecting face is made of resin. Particularly in case of a white LED package using a blue LED chip, a surface of the resin is photoaged by an influence of a low wavelength contained in the blue chip and thus a reflectivity on the reflecting face is lowered to result in a rapid lowering in brightness of the package. In manufacture of the LED housing molded by the metal injection molding, metal powder and resin powder are putted together in a mold to be injection molded and then putted in a solvent to leave resin powder alone. After that, the resulting metal housing is subjected to a temperature corresponding to a melting point of the metal powder (hereinafter, referred to as incineration) to raise a bonding force of the metal powder due to melting of the metal powder particles, thereby manufacturing a single metal housing.

In the metal injection molding, a continuous furnace is used in the incineration. At this time, the housings with a low bonding force are subjected to slight different temperatures and thus are not equal in their specification after the incineration. Therefore, it is difficult to automate lead-framing of the housing and manufacture a LED package using the lead-framed housing.

Particularly, the reflecting face of the conventional LED housing molded using the metal injection molding has an extremely uneven surface since it is formed by bonding of metal particles, and thus cannot completely net reflect the light emitted from the LED but has a high retroreflctance or diffuse reflectance, resulting in rapid lowering in the brightness.

### [Disclosure]

### [Technical Problem]

An object of the present invention is to provide a press-forged LED metal housing and a LED metal package using the same.

Another object of the present invention is to provide a LED metal housing which includes a housing body having a chip mount formed in an upper middle portion of the housing body and mounting one or more LED therein; and a reflecting projection formed around the chip mount on the upper face of the housing body integrally with the housing body, wherein the housing body and the reflecting projection are made of a metal material, and a press-forged LED metal package formed using the same.

Further another object of the present invention is to provide a LED metal housing, in which the LED housing can be have a regular volume (size) and thus be standardized by forming the housing body for mounting the LED chip therein and the reflecting projection with metal material and it is possible to automate, with a high working ratio, a series of processes of automatically mounting the LED, connecting the electrode lead, mounting the lead frame and dispensing resin (casting resin, silicone), and thus massively produce the LED metal package and reduce (lower) a production cost by the standardization of the LED housing, and a LED metal package using the same.

Yet another object of the present invention is to provide a press-forged LED metal housing in which there is no retroreflection or diffuse reflection and thus brightness of the reflecting face can be enhance by forming the housing body and the reflecting projection with metal by press-forging and there is no lowering in the brightness and thus light emitted from the LED can be utilized efficiently since the reflecting face is made of metal, and a LED metal package using the same.

### [Technical Solution]

In one aspect, the present invention provides a press-forged light emitting diode (LED) metal housing (1) having one or more LED chip (2) mounted in an upper middle portion of the housing, wherein a chip mount (11) and a reflecting face of the LED housing are formed of a single metal material and the single metal material is molded by press-forging.

### [Advantageous Effects]

The LED metal housing in accordance with the present invention includes a housing body having a chip mount formed in an upper middle portion of the housing body and mounting one or more LED therein; and a reflecting projection formed around the chip mount on the upper face of the housing body integrally with the housing body, wherein the housing body and the reflecting projection are made of a metal material, and the LED housing can be have a regular volume (size) and thus be standardized by forming the housing body for mounting the LED chip therein and the reflecting projection with metal material and it is possible to automate, with a high working ratio, a series of processes of automatically mounting the LED, connecting the electrode lead, mounting the lead frame and dispensing resin (casting resin or silicone), and thus massively produce the LED metal package and reduce (lower) a production cost by the standardization of the LED housing.

Also, since the housing body and the reflecting projection are made of metal by press-forging, the reflecting face is smooth and thus reflectance is raised to enhance the brightness of the LED package, thereby capable of utilizing efficiently the light emitted from the LED.

### [Description of Drawings]

Fig. 1 is a perspective view illustrating a LED metal housing in accordance with an embodiment of the present invention.
Figs. 2 through 4 are a plan view, a bottom view and a front view illustrating the LED metal housing in accordance with an embodiment of the present invention illustrated in Fig. 1.
Fig. 5 is a perspective view illustrating a quadrupole LED metal package in which LEDs are mounted in the LED metal housing in accordance with an embodiment of the present invention.
Figs. 6 through 9 are a plan view, a bottom view and a side view illustrating the LED metal package in accordance with an embodiment of the present invention illustrated in Fig. 5.

### <Description of main elements>

1: LED metal housing 2: bipolar LED housing
3: package with four external electrodes
10: housing body 11: chip mount
12-1, 12-2 bipolar internal electrode
13-1, 13-2 external electrode installation groove
14-1, 14-2 quadrupole internal electrode
15-1, 15-2 external electrode 20: reflecting projection
21: circular reflecting face 25: casting resin

### [Best Mode]

Hereinafter, the embodiments of the present invention will be described in detail with reference to accompanying drawings.

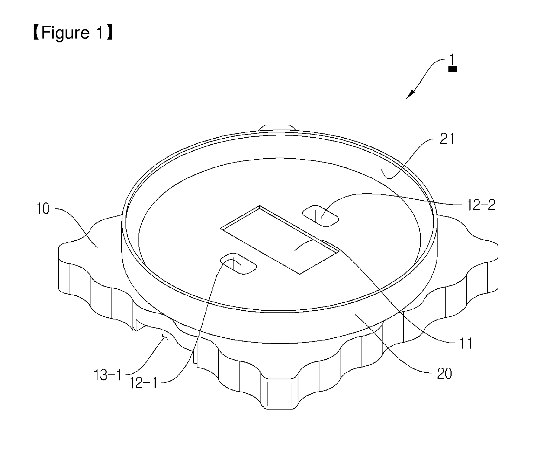

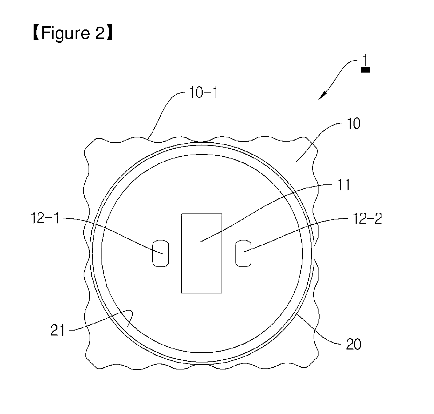

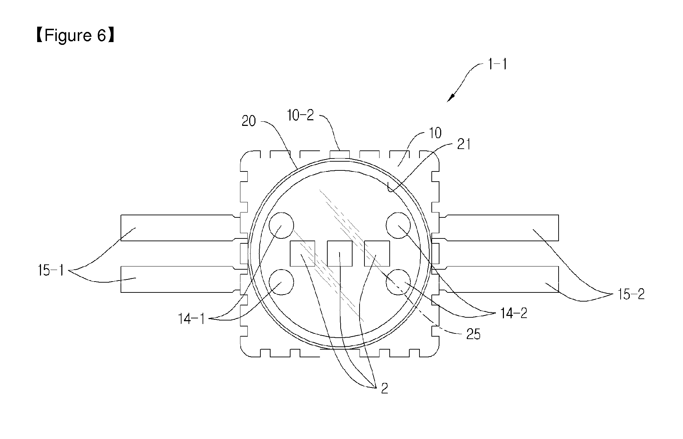

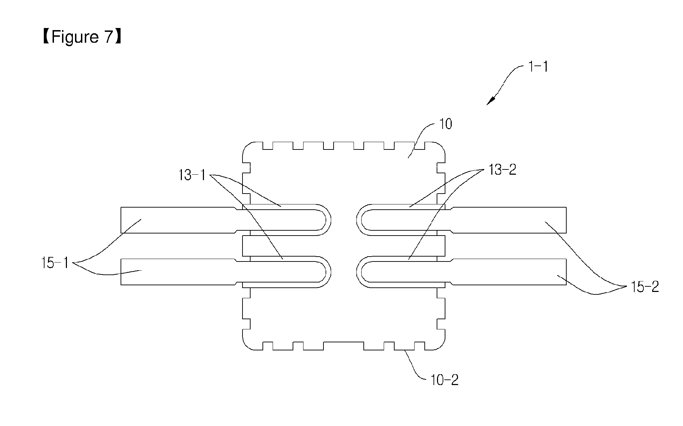

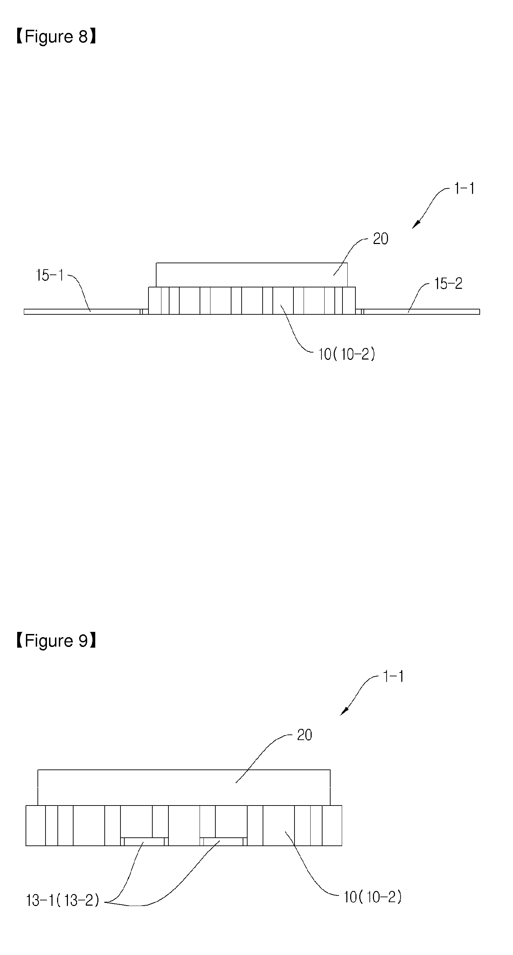

Figs. 1 through 9 illustrate a press-forged LED metal housing 1 in accordance with an embodiment of the present invention and a LED metal package 1-1 using the press-forged LED metal housing 1.

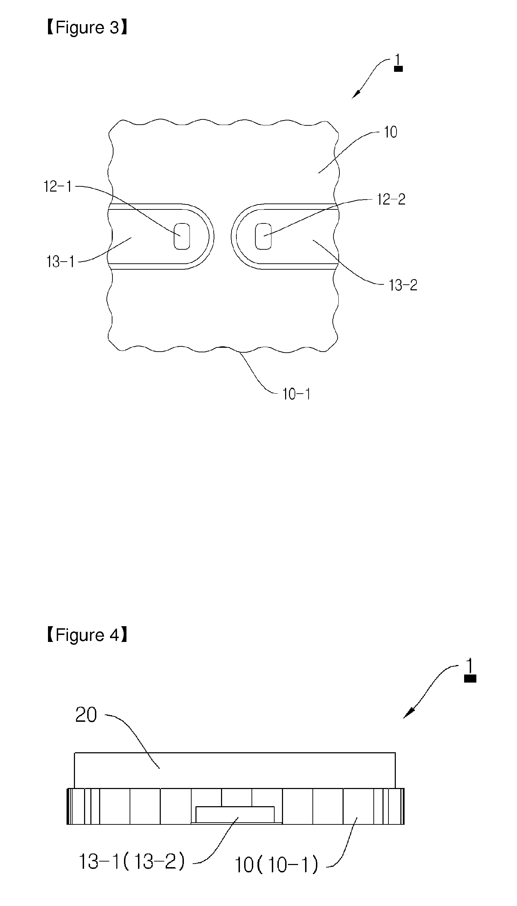

Figs. 1 through 4 are a perspective view, a plan view, a bottom view and a front view illustrating the press-forged LED metal housing 1 in accordance with an embodiment of the present invention; and Figs. 3 through 4d are a perspective view, a plan view, a bottom view and a side view illustrating the LED metal package 1-1 manufactured using the press-forged LED metal housing 1 in accordance with an embodiment of the present invention.

The press-forged LED metal housing 1 in accordance with an embodiment of the present invention was formed as follows.

As illustrated, a housing body 10 formed in a rectangular shape (square shape) or a disc shape (not specifically illustrated) has an external surface (side surface) formed in a curved concavo-convex surface 10-1 to enlarge a surface area and thus raise a heat radiation efficiency or in a rectangular concavo-convex surface 10-2 to strengthen a strength.

When a chip mount 11 is formed in an upper middle portion of the housing body 10 to mount (install) LED chips 2, it is possible to save a fluorescent substance which is mixed with casting resin (or silicone) upon manufacture of a white LED package, but the chip mount 11 is not necessarily required. One or more internal terminal hole 12-1, 12-2 is punched at both sides of the chip mount 11 and one or more terminal installation groove 13-1, 13-2 is formed on the bottom of the housing body 10 so as to communicates the wiring hole 12-1, 12-2 with the outside.

A reflecting projection 20 of which an internal surface is a circular reflecting face 21 is formed around the chip mount 11 on the upper surface of the housing body 10 integrally with the housing body 10.

The LED metal housing 1 in which the reflecting projection 20 is integrally formed on the upper surface of the housing body 10 is formed of metal, and the LED metal housing 1 is manufactured by molding metal through a multi-stage continuous process using a multi-stage mold and can be massively produced with high precision since it is manufactured in a mold.

The press-forging is a well known technique and thus will not be described in detail.

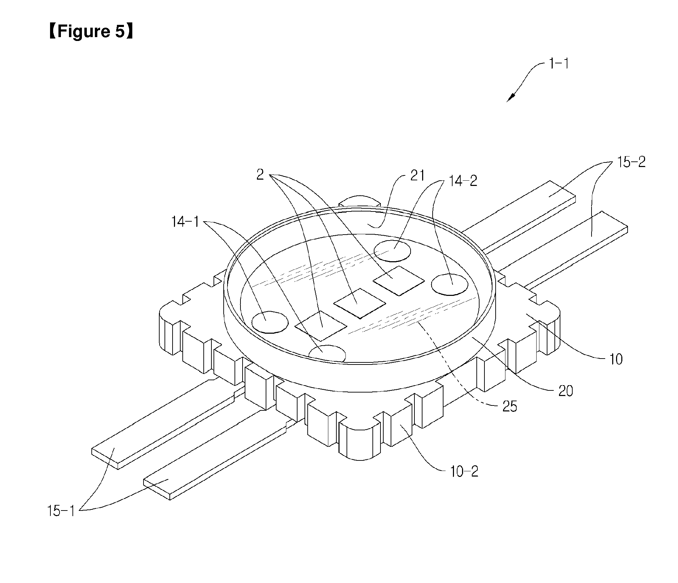

The LED metal package 1-1 is manufactured as illustrated in Figs. 5 through 9 using the LED metal housing 1 formed (molded) of metal as described above.

One or more LED chip 2 is generally mounted in the chip mount 11 of the housing body 10 that forms the LED metal housing 1, and an electrode lead of each LED chip is formed such that internal electrode 14-1, 14-2 connected from an external electrode is placed in the middle of the wiring hole 12-1, 12-2 installed so as not to be in contact with the housing body 10 by an insulation means and the external electrode 15-1, 15-2 is fixedly inserted in the terminal installation groove 13-1, 13-2 on the bottom of the housing body 10 under the internal electrode 14-1, 14-2.

After one or more LED chip 2 is mounted in the chip mount 11 of the housing body 10 and connected to the electrode lead as described above, casting resin 25 is dispensed over the LED chip 2 including the electrode lead to fill an inside of the reflecting projection 20, thereby completing manufacture of the LED metal package 1-1.

Particularly, the LED metal housing 1 in accordance with an embodiment of the present invention, which is molded by press-forging, maintains a regular standard since the integrally molded housing body 10 and reflecting projection 20 are molded very precisely without irregular contraction which is generated in a conventional metal injection molding.

Since the press-forged LED metal housing 1 can be standardized precisely, it is possible to automate, with a high working ratio, a series of processes of automatically mounting the LED, connecting the electrode lead, mounting the lead frame and dispensing resin (casting resin), and thus massively produce the LED metal package 1-1 and reduce (lower) a production cost.

Those skilled in the art will appreciate that the conceptions and specific embodiments disclosed in the foregoing description may be readily utilized as a basis for modifying or designing other embodiments for carrying out the same purposes of the present invention. Those skilled in the art will also appreciate that such equivalent embodiments do not depart from the spirit and scope of the invention as set forth in the appended claims.

### [Industrial Applicability]

The present invention provides a LED metal housing which includes a housing body having a chip mount formed in an upper middle portion of the housing body and mounting one or more LED therein; and a reflecting projection formed around the chip mount on the upper face of the housing body integrally with the housing body, wherein the housing body and the reflecting projection are made of a metal material, and a press-forged LED metal package formed using the same.

## Claims

1. A press-forged light emitting diode (LED) metal housing having one or more LED chip (2) mounted in an upper middle portion of the housing, wherein a chip mount (11) and a reflecting face of the LED housing are formed of a single metal material and the single metal material is molded by press-forging.

2. A press-forged light emitting diode (LED) metal package in which one or more LED chip (2) is mounted in a middle portion of a reflecting projection (20) formed on an upper face of a LED housing and an external electrode (15-1, 15-2) connected with the LED chip (2) is formed projecting toward both sides of the LED housing and a casting material (25) is filled in an inside of the reflecting projection (20), wherein the one or more LED chip (2) is mounted in the middle portion of a reflecting projection (20) of the LED housing made of metal, and the casting material (25) is filled in the inside of the reflecting projection (20).

3. The LED metal housing of claim 1, wherein a housing body (10) for mounting the LED chip (2) therein includes the chip mount (11) for the mount of the LED chip (2), which is formed in the upper middle portion of the housing body (10); one or more wiring hole (12-1)(12-2) punched at both sides of the chip mount (11) and opened to top and bottom thereof; and one or more external electrode installation groove (13-1)(13-2) formed on the bottom of the housing body 10 so as to communicates the wiring hole (12-1)(12-2) with an outside.

4. The LED metal housing of claim 1, wherein a housing body (10) for mounting the LED chip (2) therein has a side surface formed in a curved concavo-convex surface (10-1) or in a rectangular concavo-convex surface (10-2).
